# EUROPEAN PATENT APPLICATION

(11) **EP 4 734 744 A2**
(43) Date of publication of application: **29.04.2026**
(21) Application number: 25226871.9
(22) Date of filing: 15.03.2022
(51) Int. Cl.: H10W 90/00

(54) **PACKAGE SUBSTRATE, SEMICONDUCTOR DEVICE, AND ELECTRONIC DEVICE**

(30) Priority: 26.03.2021 CN 202110327232
(62) Divisional of application: 22774081.8
(71) Applicant: Huawei Technologies Co., Ltd., Shenzhen, Guangdong 518129 (CN)
(72) Inventor: PENG, Xiping, SHENZHEN, 518129 (CN); YUAN, Zhenhua, SHENZHEN, 518129 (CN)
(74) Representative: Körber, Martin Hans

(57) **Abstract**

This application provides a package substrate, a semiconductor device, and an electronic device, to reduce crosstalk between pins of a chip, and reduce a packaging area by increasing utilization of pins, thereby reducing development costs of the semiconductor device. The package substrate includes a substrate body and a plurality of unit regions disposed on the substrate body. The unit region includes two first solder ball structures. The first solder ball structure includes six first solder balls. The six first solder balls are arranged, with two of them in a row, to form three parallel rows of two solder balls: a first row of solder balls, a second row of solder balls, and a third row of solder balls. Four first solder balls in the first row of solder balls and the second row of solder balls are respectively located at four vertices of one parallelogram, and four first solder balls in the second row of solder balls and the third row of solder balls are respectively located at four vertices of the other parallelogram; and the two parallelograms are arranged axisymmetric about the second row of solder balls.

## Description

### CROSS-REFERENCE TO RELATED APPLICATIONS

This application claims priority to Chinese Patent Application No. 202110327232.8, filed with the China National Intellectual Property Administration on Friday, March 26, 2021 and entitled "PACKAGE SUBSTRATE, SEMICONDUCTOR DEVICE, AND ELECTRONIC APPARATUS", which is incorporated herein by reference in its entirety.

### TECHNICAL FIELD

This application relates to the field of electronic device technologies, and in particular, to a package substrate, a semiconductor device, and an electronic device.

### BACKGROUND

With the development of computer technologies and communications technologies, a speed of data exchange between a processor and a memory chip of some electronic devices such as communications device, server, and computer is continuously improved, which continuously raises requirements for a memory bus bit width, storage density, and the like, and also poses a corresponding challenge to a chip packaging technology. For the pin arrangement of a package substrate of a chip, there are two main requirements: one is to reduce electromagnetic crosstalk between pins as much as possible, and the other is to reduce the package area of the chip as much as possible, that is, to implement high-density arrangement of pins. However, increasing the pin arrangement density inevitably causes an increase of electromagnetic crosstalk. Based on this, how to arrange the pins of the package substrate in a low-crosstalk and high-density manner has become a technical problem that needs to be urgently resolved at present.

### SUMMARY

This application provides a package substrate, a semiconductor device, and an electronic apparatus, so as to reduce crosstalk between pins of a chip, and reduce a packaging area by increasing an arrangement density of pins, thereby reducing development costs of the semiconductor device.

According to a first aspect, this application provides a package substrate, where the package substrate includes a substrate body and a plurality of unit regions disposed on the substrate body. A unit region may include two first solder ball structures, and each first solder ball structure may include six first solder balls. The six first solder balls may be arranged, with two of them in a row, to form three rows of solder balls that are parallel to each other: a first row of solder balls, a second row of solder balls, and a third row of solder balls. The four first solder balls in the first row of solder balls and the second row of solder balls may be respectively located at four vertices of a parallelogram, and the four first solder balls in the second row of solder balls and the third row of solder balls may be respectively located at four vertices of the other parallelogram. In this case, a connection line between the two first solder balls in the second row of solder balls becomes a common side of the two parallelograms, and the two parallelograms are arranged axisymmetric about the second row of solder balls.

In the foregoing solution, the six first solder balls included in the first solder ball structure in the unit region are arranged in a double-parallelogram manner, which can not only helps reduce crosstalk between the first solder balls, but can increase an arrangement density of the first solder balls, thereby reducing a packaging area and further reducing development costs of a semiconductor device.

During specific arrangement, two first solder ball structures in each unit region may be arranged opposite to each other, and the second rows of solder balls of the two first solder ball structures may be arranged in a collinear manner. In this way, each unit region occupies less space, thereby reducing a packaging area.

In some possible implementation solutions, the six first solder balls in the first solder ball structure may be respectively two differential signal solder balls and four single-ended signal solder balls, where the two differential signal solder balls are a pair. During specific arrangement, the two differential signal solder balls may be located in the second row of solder balls, that is, a side formed by a connection line of the two differential signal solder balls is a common side of the two parallelograms, and the four single-ended signal solder balls are respectively arranged in the first row of solder balls and the third row of solder balls. Based on a symmetric structure of the two parallel quadrilaterals, two single-ended solder balls in the first row and two single-ended solder balls in the third row are symmetrically distributed on two sides of a pair of differential signal solder balls. Because the two signals of the pair of differential signal solder balls have equal amplitudes and opposite phases, impact of the pair of differential signal solder balls on the single-ended signal solder balls can be mutually offset, thereby reducing electromagnetic interference caused by differential signals to single-ended signals.

In some possible implementation solutions, ground solder balls may be arranged around a first solder ball structure to reduce mutual crosstalk between adjacent first solder ball structures.

A plurality of ground solder balls may be arranged around a first solder ball structure, so that return current solder balls may be formed around the first solder ball structure, thereby reducing electromagnetic interference between the first solder ball structure and another first solder ball structure.

During specific arrangement, a quantity of ground solder balls arranged around each first solder ball structure may be 11, and connection lines of the 11 ground solder balls sequentially arranged along a periphery of a first solder ball structure may form a nonagon. In this arrangement method, a relatively larger quantity of ground solder balls may be arranged around each single-end signal solder ball, thereby effectively reducing electromagnetic crosstalk between signals.

In some possible implementation solutions, a first solder ball structure may include a first side, a second side, a third side, and a fourth side. The first side is a side that is of the first solder ball structure and that is away from another first solder ball structure in a unit region. The second side is opposite to the first side. The third side and the fourth side are both located between the first side and the second side, and the third side is opposite to the fourth side. On the first side of the first solder ball structure, connection lines of a plurality of ground solder balls may form a sawtooth shape. On the second side of the first solder ball structure, connection lines of a plurality of ground solder balls may form a trapezoid shape. On the third side and the fourth side of the first solder ball structure, connection lines of a plurality of ground solder balls are respectively in a straight-line shape. This arrangement manner can better match an arrangement form of the double parallelograms of the first solder ball structure, so that the 11 ground solder balls may be close to an outer side of single-ended signal solder balls, thereby decreasing an arrangement area of ground solder balls and further reducing a packaging area.

In each unit region, the two first solder ball structures may share a plurality of ground solder balls on their respective second sides. In this way, a quantity of arranged ground solder balls can be reduced without compromising a signal anti-interference capability, thereby decreasing an arrangement area of ground solder balls.

In some possible implementation solutions, two unit regions adjacent in a row direction are staggered along a column direction. The first sides of the two adjacent first solder ball structures that are respectively located in the two adjacent unit regions in the row direction have an overlapping part, and the two unit regions adjacent in the row direction may share a plurality of ground solder balls in the overlapping part. In this way, a quantity of ground solder balls that are arranged can be reduced without compromising the signal anti-interference capability.

In some possible implementation solutions, two unit regions adjacent in a column direction may be symmetrically arranged, and in two symmetric first solder ball structures in the two unit regions adjacent in a column direction, a third side of one first solder ball structure and a fourth side of the other first solder ball structure overlap, and an overlapping side of the two first solder ball structures may share a plurality of ground solder balls. Similarly, this arrangement manner may also reduce a quantity of arranged ground solder balls without compromising the signal anti-interference capability.

According to a second aspect, this application further provides a semiconductor device. The semiconductor device may include a chip and the package substrate in any one of the foregoing possible implementation solutions. The chip is arranged on the package substrate, and signal pins on the chip are electrically connected to a plurality of first solder balls on the package substrate. The arrangement manner of solder balls on the package substrate may not only reduce electromagnetic crosstalk between signals, but increase an arrangement density of solder balls, thereby reducing a packaging area and further reducing development costs of the semiconductor device.

In some possible implementation solutions, a chip may be specifically a central processing unit. The central processing unit is provided with a plurality of memory channels. A memory channel includes a plurality of byte units, and each byte unit corresponds to one unit region. A first solder ball in a unit region may be used to transmit data signals of a corresponding byte unit.

According to a third aspect, this application further provides an electronic device. The electronic device may include a circuit board and the semiconductor device in the foregoing solution. The semiconductor device is disposed on the circuit board, and signal pins configured to connect to the semiconductor device are disposed on the circuit board. In this way, the semiconductor device may be connected to another device by using the signal pins and a trace on the circuit board, thereby implementing a connection between a chip and an external circuit.

### BRIEF DESCRIPTION OF DRAWINGS

FIG. 1 is a schematic diagram of a local structure of an electronic device according to an embodiment of this application;
FIG. 2 is a schematic diagram of a structure of a package substrate according to an embodiment of this application;
FIG. 3 is a schematic diagram of a structure of an arrangement of first solder balls on a package substrate according to an embodiment of this application;
FIG. 4 is a schematic diagram of a structure of another arrangement of solder balls on a package substrate according to an embodiment of this application;
FIG. 5 is a schematic diagram of a structure of an arrangement of unit regions on a package substrate according to an embodiment of this application;
FIG. 6 is a schematic diagram of a hardware architecture of a CPU DDR interface according to an embodiment of this application; and
FIG. 7 is a schematic diagram of a CPU DDR interface according to an embodiment of this application.

Reference numerals:
100: circuit board; 200: semiconductor device; 10: package substrate; 20: chip; 30: heat dissipation substrate; 40: filling adhesive;
11: substrate body; 12: first solder ball structure; 13: first solder ball; 1201: first row of solder balls; 1202: second row of solder balls;
1203: third row of solder balls; 14: unit region; 15: differential signal solder ball;
16, 16a, 16b, 16c, and 16d: single-ended signal solder balls; 17: ground solder ball; 21: CPU; 22: DDR channel;
23: byte unit.

### DESCRIPTION OF EMBODIMENTS

To make the objectives, technical solutions, and advantages of this application clearer, the following further describes this application in detail with reference to the accompanying drawings. It should be noted that, in the description of this application, "at least one" means one or more, and "a plurality of" means two or more. In view of this, in embodiments of the present invention, "a plurality of" may also be understood as "at least two". The term "and/or" describes an association relationship between associated objects and indicates that three relationships may exist. For example, A and/or B may indicate the following three cases: Only A exists, both A and B exist, and only B exists. In addition, the character "/", unless otherwise specified, generally indicates an "or" relationship between the associated objects. In addition, it should be understood that terms such as "first" and "second" in the description of this application are merely used for distinguishing and description, but should not be understood as indicating or implying relative importance, or should not be understood as indicating or implying a sequence.

Reference to "an embodiment", "some embodiments", or the like described in this specification indicates that one or more embodiments of this application include a specific feature, structure, or characteristic described with reference to the embodiments. Therefore, statements such as "in an embodiment", "in some embodiments", "in some other embodiments", and "in other embodiments" that appear at different places in this specification do not necessarily refer to a same embodiment. Instead, the statements mean "one or more but not all of embodiments", unless otherwise specifically emphasized in another manner. The terms "include", "comprise", and "have", and variants thereof all mean "include but are not limited to", unless otherwise specifically emphasized in another manner.

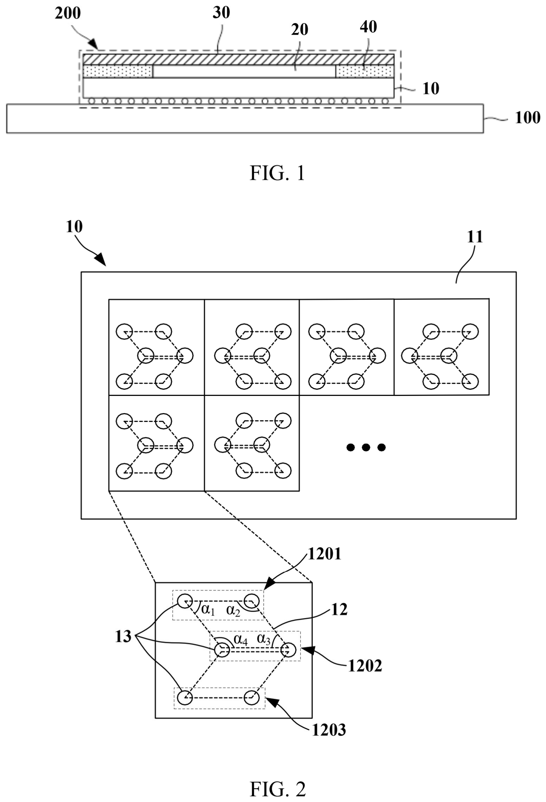

FIG. 1 is a schematic diagram of a local structure of an electronic apparatus according to an embodiment of this application. The electronic device may be a device in the conventional technology, such as a communications device, a server, a super computer, a router, or a switch. The electronic apparatus may include a circuit board 100 and a semiconductor device 200 disposed on the circuit board 100. The semi-conductor device 200 may include a package substrate 10 and a chip 20. The package substrate 10 is used as a carrier of the chip 20, and may be used to provide the chip 20 with various functions, such as power supply connection, protection, support, heat dissipation, assembly, and the like. When the semi-conductor chip is packaged, the chip 20 may be placed on the package substrate 10, and all pins on the chip 20 are connected to solder balls or solder pads of the package substrate 10 through wire bonding or flip chip.

To improve heat dissipation of the chip 20, a heat dissipation substrate 30 may be further disposed on a side that is of the chip 20 and that is away from the package substrate 10. Heat generated when the chip 20 is working may be dissipated to the outside through the lower-side package substrate 10 and the upper-side heat dissipation substrate 30. A filling adhesive 40 may be further disposed between the package substrate 10 and the heat dissipation substrate 30. On one hand, the filling adhesive 40 may be used to wrap the chip 20, to reduce adverse impact of external dust, impurities, and the like on performance of the chip 20. On the other hand, the filling adhesive 40 may be used to bond components together, such as the package substrate 10, the heat dissipation substrate 30, and the chip 20, thereby improving structural reliability of the semiconductor device 200.

The semiconductor device 200 may be fixed onto the circuit board 100 through welding or the like. Signal pins configured to connect to the semiconductor device 200 may be disposed on the circuit board 100. External pins on the semiconductor device 200 may be electrically connected to the signal pins, and then connected to another component by using the signal pins and wires on the circuit board 100 in sequence, so as to implement a connection between the internal chip 20 and an external circuit.

A quality of a semiconductor packaging technology directly affects performance of the chip 20 and design and manufacturing of the circuit board 100 connected to the chip 20. An important indicator for measuring performance of the semiconductor packaging technology is a ratio of an area of the chip 20 to a packaging area. A smaller ratio indicates a larger packaging area, that is, a larger size of the semiconductor device 200. An increase in a size of the semiconductor device 200 causes a decrease in a manufacturing yield of the semiconductor device and an increase in a welding risk of the circuit board 100, and further increases a manufacturing cost and a reliability risk of products. On the contrary, if the ratio of the area of the chip 20 to the packaging area is closer to 1, it indicates that the packaging area is smaller. In this case, the manufacturing yield of the semiconductor device 200 is higher, and the manufacturing cost may be correspondingly reduced. An arrangement density of pins on the package substrate 10 plays a key role at affecting the packaging area. To reduce the packaging area, the arrangement density of the pins needs to be increased. However, on the other side, excessively high pin arrangement density causes electromagnetic crosstalk between pins, thereby affecting performance of the chip.

To solve this problem, this application provides a package substrate. The package substrate may reduce crosstalk between pins, and may improve pin utilization through proper pin arrangement, thereby reducing the packaging area and reducing development costs of the semiconductor device. The following describes in detail the package substrate provided in this application with reference to the accompanying drawings.

FIG. 2 is a schematic diagram of a structure of a package substrate according to an embodiment of this application. As shown in FIG. 2, the package substrate 10 may include a substrate body 11 and a plurality of first solder ball structures 12 disposed on the substrate body 11. Each first solder ball structure 12 may include six first solder balls 13. The six first solder balls 13 may be arranged into a first row of solder balls 1201, a second row of solder balls 1202, and a third row of solder balls 1203 in pairs. The first row of solder balls 1201, the second row of solder balls 1202, and the third row of solder balls 1203 are parallel to each other. The four first solder balls 13 in the first row of solder balls 1201 and the second row of solder balls 1202 may be respectively located at four vertices of a parallelogram, and the four first solder balls 13 in the second row of solder balls 1202 and the third row of solder balls 1203 may be respectively located at four vertices of another parallelogram. It may be understood that a connection line between the two first solder balls 13 in the second row of solder balls 1202 is a common side of the two parallelograms. The two parallelograms may be axisymmetrically arranged based on the common side. In this case, the two parallelograms arranged based on the common side may be spliced into a dovetail. Therefore, in this embodiment of this application, the six first solder balls 13 in the first solder ball structure 12 may also be understood as being separately arranged at six vertices of the dovetail, and the common side is a central axis of the dovetail.

It should be noted that, in FIG. 2 and the following accompanying drawings, dashed connection lines between solder balls are merely used to indicate a position relationship of the solder balls, and do not exist in a specific structure of a package substrate. Therefore, the dashed connection lines do not constitute a limitation on the specific structure of the package substrate.

In a specific design, there may be a plurality of choices for inner angles of the two parallelograms. This is not limited in this application. For example, four inner angles α1, α2, α3, and α4 of the two parallelograms may be respectively 60°, 120°, 60°, and 120°.

In some embodiments, the package substrate 10 may be a substrate used to package a semiconductor chip, and a pin of the semiconductor chip may be connected to a plurality of first solder balls 13 on the package substrate 10 by using leads. Therefore, the first solder balls 13 of the first solder ball structures 12 may also be understood as pins of the package substrate 10.

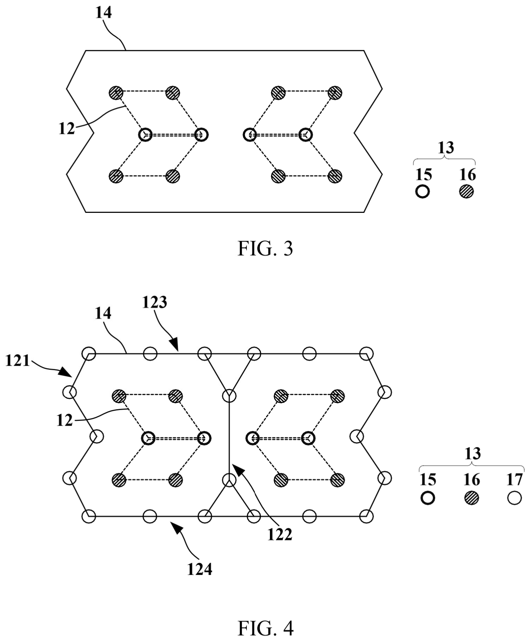

FIG. 3 is a schematic diagram of a structure of an arrangement of first solder balls on a package substrate according to an embodiment of this application. As shown in FIG. 3, in this embodiment of this application, two adjacent first solder ball structures 12 may form a unit area 14 in a geometric arrangement shape, and a plurality of unit areas 14 form a pin area of the package substrate. In each unit area 14, the two first solder ball structures 12 may be arranged opposite to each other, and central axes of the two first solder ball structures 12 are collinear.

As an example, each unit area 14 may correspond to data signals of a single byte unit, or in other words, the first solder balls 13 included in the two first solder ball structures 12 are separately used to transmit data signals of a single byte unit. Each byte unit may generally include four differential signals and eight single-end signals, and the four differential signals may be further divided into two pairs of differential signals. Two signals of each pair of differential signals have equal amplitudes and opposite phases.

The six first solder balls 13 in the first solder ball structure 12 may include two differential pair signal solder balls 15 and four single-end signal solder balls 16, and the two differential pair signal solder balls 15 are a pair. It may be understood that, in each unit area 14, two pairs of differential pair signal solder balls 15 of the two first solder ball structures 12 may correspond to two pairs of differential signals in a single byte unit, and eight single-end signal solder balls 16 may correspond to eight single-end signals in a single byte unit.

Still as shown in FIG. 3, in the first solder ball structure 12, the two differential pair signal solder balls 15 may be arranged on a central axis of a dovetail shape, that is, a side formed by the connection line of the two differential pair signal solder balls 15 is a common side of the two parallelograms. The four single-end signal solder balls 16 are respectively arranged at the other four vertices of the dovetail shape. Two single-end signal solder balls 16 and two differential pair signal solder balls 15 form a parallelogram, and the other two single-end signal solder balls 16 and the two differential pair signal solder balls 15 form another parallelogram.

Based on a dovetail-shaped symmetric structure, single-end signal solder balls 16a and 16b in the first solder ball structure 12 are symmetrically distributed on two sides of a pair of differential pair signal solder balls 15. Because two signals of a pair of differential signals have equal amplitudes and opposite phases, impact of the differential pair signal solder balls 15 on the single-end signal solder balls 16a and 16b may be mutually offset, thereby reducing electromagnetic crosstalk caused by differential signals to single-end signals. Similarly, single-end signal solder balls 16c and 16d in the first solder ball structure 12 are also symmetrically distributed on two sides of the pair of differential pair signal solder balls 15. Therefore, impact of the differential pair signal solder balls 15 on the single-end signal solder balls 16c and 16d may also be mutually offset, thereby reducing electromagnetic crosstalk caused by differential signals to single-end signals.

In addition, it can be learned from FIG. 3 that, in this embodiment of this application, there is only one single-end signal solder ball 16 adjacent to each single-end signal solder ball 16, that is, a quantity of single-end signal solder balls 16 arranged around each single-end signal solder ball 16 is small, so that electromagnetic crosstalk between single-end signal solder balls 16 can be reduced.

FIG. 4 is a schematic diagram of a structure of another arrangement of solder balls on a package substrate according to an embodiment of this application. As shown in FIG. 4, in this embodiment of this application, ground solder balls 17 may be further arranged around a first solder ball structure 12, and there may be a plurality of ground solder balls 17, so as to form return current solder balls to surround the first solder ball structure 12, thereby reducing electromagnetic interference with other solder balls.

In some embodiments, 11 ground solder balls 17 may be arranged around the first solder ball structure 12. Three ground solder balls 17 are arranged on a first side 121 of the first solder ball structure 12 that is far away from another first solder ball structure 12 in a same unit area 14. The three ground solder balls 17 on the side are respectively located at three vertices of an isosceles corner, and two sides of the corner are respectively parallel to the sides of two parallelograms facing the first side 121. Two ground solder balls 17 are arranged on a second side 122 opposite to the first side 121, and a connection line of the two ground solder balls 17 on the side 122 is arranged perpendicular to a central axis of a dovetail shape. Three ground solder balls 17 are arranged respectively on a third side 123 and a fourth side 124 adjacent to the first side 121. The three ground solder balls 17 on the third side 123 are arranged in a straight line, which is in parallel with the central axis of the dovetail shape. The three ground solder balls 17 on the fourth side 124 are also arranged in a straight line, which is also in parallel with the central axis of the dovetail shape.

It may be understood that, among the three ground solder balls 17 on the third side 123, the ground solder ball 17 closest to the first side 121 may also be considered to be located on the first side 121 at the same time, and among the three ground solder balls on the fourth side 124, the ground solder ball 17 closest to the first side 121 may also be considered to be located on the first side 121 at the same time. In this way, it may be considered that five ground solder balls 17 are arranged on the first side 121, and connection lines of the five ground solder balls 17 are arranged in a sawtooth shape on four sides. Similarly, among the three ground solder balls 17 on the third side 123, the ground solder ball 17 closest to the second side 122 may also be considered to be located on the second side 122 at the same time, and among the three ground solder balls 17 on the fourth side 124, the ground solder ball 17 closest to the second side 122 may also be considered to be located on the second side 122 at the same time. In this way, it may be considered that four ground solder balls 17 are arranged on the second side 122, and connection lines of the four ground solder balls 17 are arranged in an isosceles trapezoid shape. That is, in this embodiment, connection lines of the 11 ground solder balls arranged around the first solder ball structure 12 are presented as a nonagon. This arrangement method can better match a dovetail-shaped arrangement form of the first solder ball structure 12, so that the 11 ground solder balls 17 may stick closely to outer sides of the single-end signal solder balls 16, thereby reducing an arrangement area of the ground solder balls 17 and further enabling the package substrate to accommodate more solder balls.

In addition, the ground solder balls 17 are arranged as a nonagon around the first solder ball structure 12, so that more ground solder balls 17 may be arranged around each single-end signal solder ball 16. For example, in the embodiment shown in FIG. 3, at least three ground solder balls 17 may be arranged around each single-end signal solder ball 16, thereby effectively reducing electromagnetic interference between signals.

In each unit area 14, the two first solder ball structures 12 may share ground solder balls 17. For example, the first solder ball structure 12 on the left side and the first solder ball structure 12 on the right side may share two ground solder balls 17 in between, that is, the two ground solder balls 17 on a second side of the first solder ball structure 12. In this way, a quantity of ground solder balls 17 may be reduced without compromising a signal anti-interference capability, thereby reducing the arrangement area of ground solder balls 17 and manufacturing costs of the package substrate.

During specific arrangement, a spacing between solder balls is not limited in this embodiment of this application, and may be specifically designed based on an actual use requirement. In some embodiments, a spacing between adjacent solder balls may be between 0.8 mm and 1.2 mm. For example, a value of the spacing between adjacent solder balls may be 0.8 mm, 0.9 mm, 1 mm, 1.1 mm, 1.2 mm, or the like.

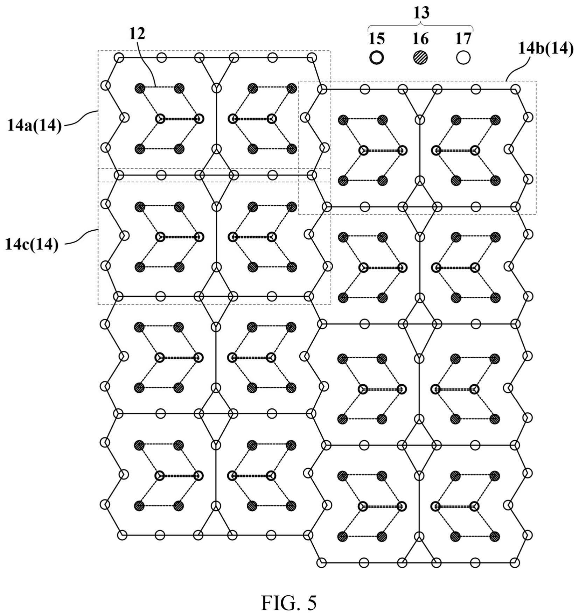

FIG. 5 is a schematic diagram of a structure of an arrangement of unit areas on a package substrate according to an embodiment of this application. As shown in FIG. 4 and FIG. 5, in this embodiment of this application, unit areas 14 may be extended horizontally or vertically to form a pin area of the package substrate. It can be learned from FIG. 5 that both a left side and a right side of a unit area 14 are in a sawtooth shape, and both an upper side and a lower side of the unit area 14 are straight-line sides. In specific design, two adjacent unit areas 14 in a row direction may be arranged in a staggered manner in a column direction. For two adjacent first solder ball structures 12 that are located in two adjacent unit areas 14 in a row direction, first sides 121 of the two first solder ball structures 12 have an overlapping portion, and the two adjacent unit areas 14 in the row direction may share a plurality of ground solder balls 17 located in the overlapping portion. That is, the right sawtooth side of a left unit area 14a may match the left sawtooth side of a right unit area 14b, and a first solder ball structure 12 disposed close to the right side in the left unit area 14a and a first solder ball structure 12 disposed close to the left side in the right unit area 14b may share three ground solder balls 17 in the overlapping portion. In this way, an arrangement area of ground solder balls 17 may be reduced, and the left and right unit areas 14 may further share part of ground solder balls 17, so that a quantity of ground solder balls 17 arranged may be reduced without compromising a signal anti-interference capability.

In addition, two unit areas 14 that are adjacent in a column direction may be symmetrically arranged. For the two symmetric first solder ball structures 12 that are respectively located in the two unit areas 14 that are adjacent in a column direction, a third side 123 of one first solder ball structure 12 overlaps a fourth side 124 of the other first solder ball structure 12, and a plurality of ground solder balls 17 on the overlapping side may be shared. For example, in the unit area 14a and a unit area 14c shown in FIG. 5, the straight-line side of a lower side (a fourth side) of the upper unit area 14a may overlap the straight-line side of an upper side (a third side) of the lower unit area 14c, and the unit area 14a and the unit area 14c may share three ground solder balls 17 on the overlapping side. Similarly, this arrangement method may not only reduce an arrangement area of ground solder balls 17, but enable part of ground solder balls 17 to be shared by the upper and lower unit areas 14, thereby reducing a quantity of arranged ground solder balls 17 without compromising the signal anti-interference capability.

It should be noted that the package substrate provided in this embodiment of this application may be configured to match a central processing unit (central processing unit, CPU) chip. In other words, the package substrate in this embodiment of this application may be used to package a CPU. The following describes a specific matching manner between the package substrate and the CPU.

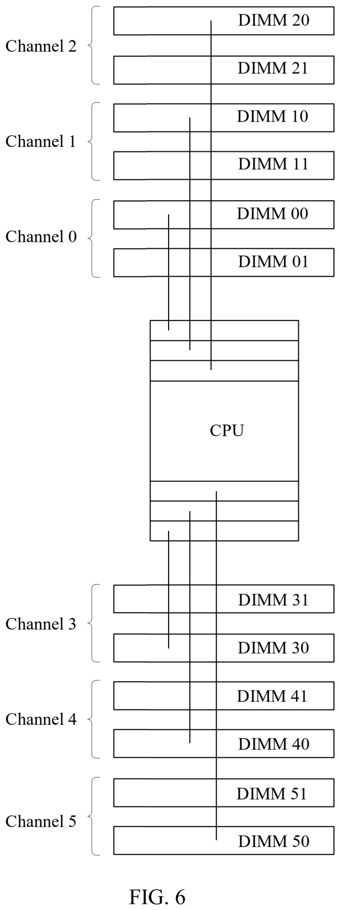

FIG. 6 is a schematic diagram of a hardware architecture of a CPU double data rate synchronous dynamic random access memory (double data rate synchronous dynamic random access memory, DDR SDRAM for short) interface according to an embodiment of this application. As shown in FIG. 6, generally there is a plurality of DDR channels (Channel) on a CPU side, and each DDR channel may drive and connect to one or more memory modules, for example, dual in-line memory modules (dual-inline-memory-modules, DIMM for short). The foregoing channel may refer to a memory channel configured for the CPU, and a memory bandwidth of a channel is generally 32 bits or 64 bits.

For example, the CPU may include six DDR channels, which are numbered 0, 1, 2, 3, 4, and 5, respectively. Channel 0 may be connected to two memory modules DIMM 00 and DIMM 01, channel 1 may be connected to two memory modules DIMM 10 and DIMM 11, channel 2 may be connected to two memory modules DIMM 20 and DIMM 21, channel 3 may be connected to two memory modules DIMM 30 and DIMM 31, channel 4 may be connected to two memory modules DIMM 40 and DIMM 41, and channel 5 may be connected to two memory modules DIMM 50 and DIMM 51. It should be understood that the CPU in this embodiment of this application is not limited to the architecture shown in FIG. 1. A quantity of channels of the CPU and a quantity of memory modules that are correspondingly connected to each channel may be set according to an actual requirement. Details are not described herein again.

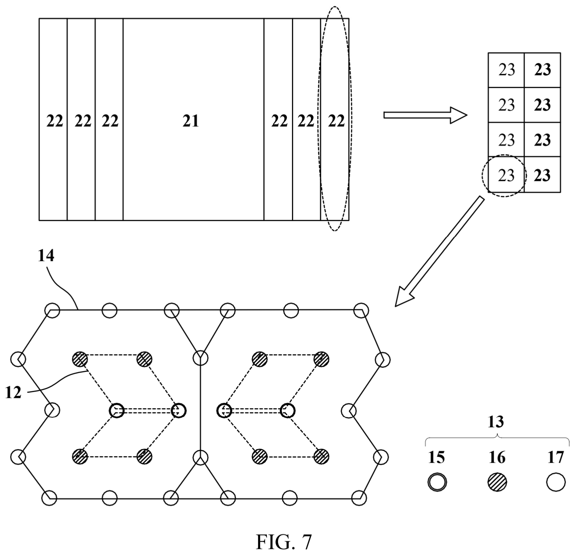

FIG. 7 is a schematic diagram of a CPU DDR interface according to an embodiment of this application. As shown in FIG. 6 and FIG. 7, a DDR channel 22 on a CPU 21 side may include a plurality of byte units 23 formed by 8 bits. It may be understood that, when a memory bandwidth of the DDR channel 22 is 32 bits, the DDR channel 22 may include four byte units 23; and when the memory bandwidth of the DDR channel 22 is 64 bits, the DDR channel 22 may include eight byte units 23. The embodiment shown in FIG. 6 is described by using an example in which the memory bandwidth of the DDR channel 22 is 64 bits.

In this embodiment, each byte unit 23 may correspond to one of the foregoing unit areas 14, that is, each byte unit 23 may correspond to two first solder ball structures 12. For the DDR channels 22 whose memory bandwidth is 64 bits, each DDR channel 22 corresponds to eight unit areas 14. The eight unit areas 14 may be arranged in a manner of 4x2 (4 refers to a quantity of rows arranged in the eight unit areas 14, and 2 refers to a quantity of columns arranged in the eight unit areas 14) shown in FIG. 4 or 2x4, or may be arranged in a same row or a same column. The specific arrangement may be performed based on space division on the package substrate. This is not limited in this application.

As proved by experiments, electromagnetic crosstalk between DDR data signals can be reduced to -33.6 dB by using the package substrate provided in this embodiment of this application to package the CPU and by using a dovetail-shaped pin layout solution of first solder ball structures 12. In addition, if it is assumed that a usable area of a unit area in a conventional trapezoidal arrangement manner is 1, a usable area of the unit area 14 in a dovetail-shaped arrangement manner in this embodiment of this application is approximately 0.95. Therefore, a packaging area can be effectively reduced.

Therefore, the dovetail-shaped pin layout solution adopted on the package substrate provided in this embodiment of this application may not only reduce electromagnetic crosstalk between DDR data signals and enable a CPU to support a higher DDR running rate, but increase utilization of pins on the package substrate, thereby effectively reducing a packaging area and helping reduce development costs of a semiconductor device.

Further embodiments of the present invention are provided in the following. It should be noted that the numbering used in the following section does not necessarily need to comply with the numbering used in the previous sections.
Embodiment 1. A package substrate, comprising a substrate body and a plurality of unit regions arranged on the substrate body, wherein
   the unit region comprises two first solder ball structures, the first solder ball structure comprises six first solder balls, and the six first solder balls are arranged, with two of them in a row, to form three parallel rows of two solder balls: a first row of solder balls, a second row of solder balls, and a third row of solder balls; the four first solder balls in the first row of solder balls and the second row of solder balls are respectively located at four vertices of a parallelogram; the four first solder balls in the second row of solder balls and the third row of solder balls are respectively located at four vertices of the other parallelogram; and the two parallelograms are arranged axisymmetric about the second row of solder balls.
Embodiment 2. The package substrate according to embodiment 1, wherein in each unit region, the two first solder ball structures are arranged opposite to each other, and the second rows of solder balls of the two first solder ball structures are arranged in a collinear manner.
Embodiment 3. The package substrate according to embodiment 1 or 2, wherein the six first solder balls of the first solder ball structure are respectively two differential signal solder balls and four single-ended signal solder balls.
Embodiment 4. The package substrate according to embodiment 3, wherein the two differential signal solder balls are arranged in the second row of solder balls.
Embodiment 5. The package substrate according to any one of embodiments 1 to 4, wherein ground solder balls are arranged around the first solder ball structure.
Embodiment 6. The package substrate according to embodiment 5, wherein a quantity of the ground solder balls arranged around each first solder ball structure is 11, and connection lines of the 11 ground solder balls sequentially arranged along a periphery of the first solder ball structure may form a nonagon.
Embodiment 7. The package substrate according to embodiment 6, wherein the first solder ball structure comprises a first side, a second side, a third side, and a fourth side, and the first side is a side that is of the first solder ball structure and that is away from the other first solder ball structure in the same unit region, the second side is opposite to the first side, the third side and the fourth side are both located between the first side and the second side, and the third side is opposite to the fourth side; and
   connection lines of a plurality of ground solder balls on the first side are arranged in a sawtooth shape, connection lines of a plurality of ground solder balls on the second side are arranged in a trapezoid shape, and connection lines of a plurality of ground solder balls on the third side and the fourth side are separately arranged in a straight-line shape.
Embodiment 8. The package substrate according to embodiment 7, wherein in each unit region, the two first solder ball structures share a plurality of ground solder balls on the second side.
Embodiment 9. The package substrate according to embodiment 7 or 8, wherein two unit regions adjacent in a row direction are staggered in a column direction, first sides of two adjacent first solder ball structures that are respectively located in the two unit regions adjacent in the row direction have an overlapping part, and the two unit regions adjacent in the row direction share a plurality of ground solder balls located in the overlapping part.
Embodiment 10. The package substrate according to any one of embodiments 7 to 9, wherein two adjacent unit regions are symmetrically arranged in a column direction, and in the two symmetric first solder ball structures in the two adjacent unit regions in the column direction, a third side of one first solder ball structure a fourth side of the other first solder ball structure overlap, and share a plurality of ground solder balls.
Embodiment 11. A semiconductor device, comprising a chip and the package substrate according to any one of embodiments 1 to 10, wherein the chip is disposed on the package substrate.
Embodiment 12. The semiconductor device according to embodiment 11, wherein the chip is a central processing unit, the central processing unit is provided with a plurality of memory channels, the memory channel comprises a plurality of byte units, each byte unit corresponds to one unit region, and the first solder balls in the unit region are configured to transmit data signals of the corresponding byte unit.
Embodiment 13. An electronic device, comprising a circuit board and the semiconductor device according to embodiment 11 or 12, wherein the semiconductor device is disposed on the circuit board, signal pins are disposed on the circuit board, and the signal pins are electrically connected to the semiconductor device.

The foregoing descriptions are merely specific implementation of the present application, but are not intended to limit a protection scope of the present application. Any variation or replacement readily figured out by a person skilled in the art within the technical scope disclosed in the present application should fall within the protection scope of the present application. Therefore, the protection scope of this application shall be subject to the protection scope of the claims.

## Claims

1. A package substrate, comprising a substrate body and a plurality of unit regions arranged on the substrate body, wherein
the unit region comprises two first pin structures, the first pin structure comprises six first pins, the six first pins are arranged, with two of them in a row, to form three parallel rows of two pins: a first row of pins, a second row of pins, and a third row of pins, the four first pins in the first row of pins and the second row of pins are respectively located at four vertices of a parallelogram, the four first pins in the second row of pins and the third row of pins are respectively located at four vertices of the other parallelogram, and the two parallelograms are arranged axisymmetric about the second row of pins; and
the two first pins in the second row of pins are differential signal pins, and the two first pins in the first row of pins and the two pins in the third row of pins are single-ended signal pins.

2. The package substrate according to claim 1, wherein in the unit region, the two first pin structures are arranged in a row direction of the second row of pins, and the two first pin structures are axisymmetric.

3. The package substrate according to claim 2, wherein in the unit region, a distance between the first rows of pins in the two first pin structures is greater than a distance between the second rows of pins in the two first pin structures.

4. The package substrate according to any one of claims 1 to 3, wherein ground pins are arranged around the first pin structure.

5. The package substrate according to claim 4, wherein a quantity of the ground pins arranged around the first pin structure is 11, and connection lines of the 11 ground pins sequentially spaced and arranged along a periphery of the first pin structure may form a nonagon.

6. The package substrate according to claim 5, wherein the first pin structures comprises a first side, a second side, a third side, and a fourth side, and the first side is a side that is of the first pin structures and that is away from the other first pin structures in the same unit region, the second side is opposite to the first side, the third side and the fourth side are both located between the first side and the second side, and the third side is opposite to the fourth side; and
connection lines of a plurality of ground pins on the first side are arranged in a sawtooth shape, connection lines of a plurality of ground pins on the second side are arranged in a trapezoid shape, and connection lines of a plurality of ground pins on the third side and the fourth side are separately arranged in a straight-line shape.

7. The package substrate according to claim 5 or 6, wherein the first pin structures comprises a first side, a second side, a third side, and a fourth side, and the first side is a side that is of the first pin structures and that is away from the other first pin structures in the same unit region, the second side is opposite to the first side, the third side and the fourth side are both located between the first side and the second side, and the third side is opposite to the fourth side; and
three ground pins are arranged on the first side, three ground pins are respectively located at three vertices of an isosceles triangle, two legs of the isosceles triangle are respectively parallel to sides that are of the two parallelograms of the first pin structure and that face the first side, two ground pins are arranged on the second side, a connection line of the two ground pins is orthogonal to the row direction of the second row of pins, three ground pins are arranged on each of the third side and the fourth side, and the three ground pins on the same side are sequentially spaced and arranged in the row direction of the second row of pins.

8. The package substrate according to claim 6 or 7, wherein in the unit region, the two first pin structures share two ground pins on the second side.

9. The package substrate according to any one of claims of claims 6 to 8, wherein the first row of pins, the second row of pins, and the third row of pins are sequentially arranged in a column direction, two adjacent unit regions in the row direction of the second row of pins are staggered in the column direction, and the two adjacent unit regions in the row direction share some of the ground pins.

10. The package substrate according to any one of claims 6 to 9, wherein the first row of pins, the second row of pins, and the third row of pins are sequentially arranged in the column direction, two adjacent unit regions in the column direction are symmetrically arranged, and the two adjacent unit regions in the column direction share some of the ground pins.

11. The package substrate according to claim 6 or 7, wherein in a basic graphics unit, a first pin and a connection line of two adjacent first pins form an equilateral triangle, the first pin is one of the pins in the first row of pins located near the first side.

12. The package substrate according to any one of claims 1 to 11, wherein connection lines of three adjacent pins in a plurality of first pins and a plurality of ground pins form an equilateral triangle, one of the plurality of first pins is one of the first row of pins or one of the third row of pins.

13. The package substrate according to any one of claims 1 to 12, wherein the chip is a central processing unit, the central processing unit is provided with a plurality of memory channels, the memory channel comprises a plurality of byte units, each byte unit corresponds to one unit region, and the single-ended signal pins in the unit region are configured to transmit data signals of the corresponding byte unit.

14. A semiconductor device, comprising a chip and the package substrate according to any one of claims 1 to 13, wherein the chip is disposed on the package substrate.

15. An electronic device, comprising a circuit board and the semiconductor device according to claim 14, wherein the semiconductor device is disposed on the circuit board, signal pins are disposed on the circuit board, and the signal pins are electrically connected to the semiconductor device.
